# EUROPÄISCHE PATENTSCHRIFT

(11) **EP 0 218 784 B1**
(45) Veröffentlichungstag und Bekanntmachung des Hinweises auf die Patenterteilung: **05.01.1994**
(21) Anmeldenummer: 86107338.5
(22) Anmeldetag: 30.05.1986
(51) Int. Cl.: H01L 39/14, H01L 39/24

(54) **Multifilament-Supraleiterdrähte und Verfahren zu deren Herstellung**
Multifilament superconductor wire and method of producing the same
Fils supraconducteurs multibrins et leur procédé de fabrication

(30) Priorität: 06.09.1985 DE 3531770
(43) Veröffentlichungstag der Anmeldung: 22.04.1987
(73) Patentinhaber: KERNFORSCHUNGSZENTRUM KARLSRUHE GMBH, D-76021 Karlsruhe (DE)
(72) Erfinder: Flükiger, René, Dr., D-7500 Karlsruhe 1 (DE)

(56) Entgegenhaltungen:
- EP-A- 0 048 313
- EP-A- 0 221 232
- US-A- 4 411 959
- JOURNAL OF APPLIED PHYSICS, Band 54, Nr. 6, Juni 1983, Seiten 3318-3324, American Institute of Physics, New York, US; J. WECKER et al.: "Effects of additives on the superconducting properties of powdermetallurgically produced Cu-Nb3Sn composite wires"
- KRISTALL UND TECHNIK, Band 13, Nr. 12, 1978, Seiten 1379-1389, Akademie Verlag, Berlin, DE; J. D. LIVINGSTON: "Metallurgy of bronze-process A-15 superconducting composites"

## Beschreibung

Die Erfindung betrifft Multifilament-Supraleiterdrähte, bestehend aus mit Kupfer oder mit Kupferlegierung umgebenen Filamenten, die aus supraleitenden, intermetallischen Verbindungen Nb₃Sn oder V₃Ga, jeweils mit A15-Struktur, mit Zusätzen aus der Gruppe der Elemente
Seltene Erdmetalle, Th, U, Ti, Zr, Hf, V, Nb, Ta, Mo, Fe, Co, Ni, Pd, Cu, Ag, Al, Pt, ausgenommen Nb als einziges Zusatzelement Für Nb₃Sn und V als einziges Zusatzelement für V₃Ga,
aufgebaut sind. Weiterhin betrifft die Erfindung ein Verfahren zur Herstellung solcher Supraleiterdrähte.

Multifilament-Supraleiterdrähte auf der Basis Bronze-Nb₃Sn mit ternären oder quaternären Zusätzen von beispielsweise Uran, Titan, Zirkonium, Hafnium, Vanadium, Tantal, Eisen, Nickel, Palladium, Aluminium oder andere sind aus der Veröffentlichung der europäischen Patentanmeldung EP-A-0 048 313 bekannt. Diese Zusätze dienen dort der Vermeidung des sogenannten Prestress-Effektes und wurden dem Niob und/oder dem Kupfer bzw. der Bronze zulegiert. Durch die in der europäischen Offenlegungsschrift beschriebenen Legierungszusammensetzungen und zur Herstellung der Supraleiterdrähte erforderlichen Maßnahmen wird die vor allem bei hohen Magnetfeldern auftretende Verschiebung der kritischen Stromstärke zu niedrigeren Werten im Vergleich zu dem maximalen Wert stark verringert bzw. verhindert.

Mit den bekannten Methoden zur Herstellung von Nb₃Sn- oder V₃Ga-Multifilament-Supraleiterdrähten erhält man Produkte, welche bei mittleren Magnetfeldern (12 T) kritische Stromdichtewerte um 10⁵ A/cm² aufweisen.

Der Erfindung liegt die Aufgabe zugrunde, verbesserte Multifilament-Supraleiterdrähte, bestehend aus mit Kupfer oder mit Kupferlegierung umgebenen Filamenten, die aus supraleitenden intermetallischen Verbindungen Nb₃Sn oder V₃Ga, jeweils mit A15-Kristall-Struktur, mit Zusätzen aufgebaut sind, bereitzustellen und herzustellen, welche in Magnetfeldern ihres Anwendungsbereiches, vor allem in Magnetfeldern im Bereich unterhalb 12 T, erhöhte Stromdichte-Werte um mehr als 10 % oder höher gegenüber den bisher mit den genannten Materialien erreichbaren Werten gewährleisten.

Die Aufgabe wird erfindungsgemäß gelöst durch Multifilament-Supraleiterdrähte, bestehend aus mit Kupfer oder mit Kupferlegierung umgebenen Filamenten, die aus supraleitenden, intermetallischen Verbindungen Nb₃Sn oder V₃Ga, jeweils mit A15-Struktur, mit Zusätzen aus der Gruppe der Elemente
Seltene Erdmetalle, Th, U, Ti, Zr, Hf, V, Nb,Ta, Mo, Fe, Co, Ni, Pd, Cu, Ag, Al, Pt ausgenommen Nb als einziges Zusatzelement für Nb₃Sn und V als einziges Zusatzelement für V₃Ga,
aufgebaut sind, welche dadurch gekennzeichnet sind, daß innerhalb der A15-Phase an den Korngrenzen der Kristalle und/oder an den Grenzflächen der A15-Phase zum Kupfer oder zur Kupferlegierung homogen verteilte, ungelöste Einschlüsse vorliegen, die eine weitere Phase bilden und aus mindestens einem Element der Gruppe bestehen.

Das Zusatzelement im Einschluß kann unreagiert in elementarer Form oder nach Reaktion mit Elementen der Umgebung als Reaktionsprodukt in Form einer separaten Phase vorliegen. Mit den genannten Zusätzen können sowohl binäre Leiter (z.B. Nb₃Sn- oder V₃Ga-Leiter) als auch multinäre Leiter (das sind solche, die ternäre oder quaternäre etc. Legierungsbestandteile in der A15-Struktur aufweisen) versehen sein, wenn diese Zusätze Einschlüsse, d.h. separate Phasen, bilden. Die Einschlüsse weisen allgemein radiale Abmessungen von 0,5 µm oder kleiner auf. In einer vorteilhaften Ausbildung der Erfindung weisen die Einschlüsse radiale Abmessungen von weniger als 0,1 µm auf. Für die Erfindung ist es ebenfalls von Vorteil, wenn die Einschlüsse achsenparallel ausgebildet sind. Die Summe der Zusätze in den Einschlüssen kann einer Konzentration im Bereich von 0,1 Gew.-% bis 50 Gew.-%, bezogen auf den Nb-Anteil der A15-Phase im Falle von Nb₃Sn und bezogen auf den V-Anteil der A15-Phase im Falle von V₃Ga, entsprechen.

Der Teil der Aufgabe, der sich mit der Herstellung der erfindungsgemäßen Multifilament-Supraleiterdrähte befaßt, wird erfindungsgemäß dadurch gelöst, daß man
a) ein metallisches Pulver aus einem der genannten Zusatzmetalle mit Ausnahme von V und Nb oder aus mehreren der genannten Zusatzmetalle oder aus einer oder mehreren Legierungen aus mindestens zwei der Zusatzmetalle mischt mit einem Pulver
   a₁) aus Niob, oder
   a₂) aus einer oder mehreren Nb-Legierungen aus der Gruppe Nb-Ta, Nb-Ti, NbZr oder
   a₃) aus Vanadium oder
   a₄) aus einer oder mehreren V-Legierungen aus der Gruppe V-Ta, V-Nb, V-Ti, V-Zr,
   wobei alle Pulver Korngrößen aufweisen im Bereich zwischen 0,1 µm und 400 µm Durchmesser und der Anteil y des bzw. der Zusatzmetalle im Pulvergemisch einem Gewichtsprozentwert innerhalb der Grenzen 0,1 ≦ y ≦ 50 entspricht,
b) das aus a) erhaltene Pulvergemisch in einen kompaktierbaren und evakuierbaren Behälter aus Kupfer oder aus einer Kupferlegierung einfüllt, die eingeschlossene Luftmenge entfernt und danach das Pulvergemisch mit dem geschlossenen Behälter durch einfaches oder isostatisches Pressen gemeinsam kompaktiert bis zu einer Pulverdichte von mehr als 90 % theoretische Dichte und
c) den kompaktierten Behälter in an sich bekannter Weise zu einem Draht mit einem Durchmesser im Bereich von 0,5 mm bis 15 mm verformt und nach Entfernen der äußeren Cu- oder Cu-Legierungs-Schicht nach einer der bekannter Verfahrensweisen zu Nb₃Sn-Drähten oder zu V₃Ga-Drähten weiterverarbeitet.

Eine andere Version des erfindungsgemäßen Verfahrens ist dadurch gekennzeichnet, daß man
a)Stäbe und/oder Drähte aus einem der genannten Zusatzmetalle mit Ausnahme von V und Nb oder aus mehreren der genannten Zusatzmetalle und/oder aus einer oder mehreren Legierungen aus mindestens zwei der Zusatzmetalle in Rohre
   a₁) aus Niob, oder
   a₂) aus einer oder mehreren Nb-Legierungen aus der Gruppe Nb-Ta, Nb-Ti, Nb-Zr oder
   a₃) aus Vanadium oder
   a₄) aus einer oder mehreren V-Legierungen aus der Gruppe V-Ta, V-Nb, V-Ti, V-Zr
   einführt, wobei der Anteil z des bzw. der Zusatzmetalle im Gesamtverbund Stäbe/Drähte-Rohre einem Gewichtsprozentwert innerhalb der Grenzen 0,1≦z ≦ 50 entspricht,
b) die gefüllten Rohre zu hexagonalen Querschnitten in an sich bekannter Weise plastisch verformt,
c) die hexagonalen Rohre bündelt zu einer dichten Packung, diese in ein Rohr aus Cu oder aus einer Cu-Legierung einsetzt, letztere in bekannter Weise zu runden Stäben verformt, die äußere Schicht aus Cu oder Cu-Legierungen vollständig oder teilweise entfernt und nach einer der bekannten Verfahrensweisen zu Nb₃Sn-Drähten oder zu V₃Ga-Drähten weiterverarbeitet.

Das Vorliegen gleichmäßig und fein verteilter ungelöster oder zumindest zum Teil ungelöster Einschlüsse aus den genannten Zusatzelementen bzw. Zusatzmetallen im Multifilament-Supraleiterdraht bringen folgende Veränderungen mit sich:
Verringerung der Korngrößen
Erhöhung der Dichte der Haftzentren (pinning centers)
Erhöhung der Grenzflächensumme
Erhöhung der kritischen Stromdichte bei mittleren Magnetfeldern.

Bei der Reaktion zur supraleitenden Verbindung bzw. zur A15-Struktur gegen Ende des Herstellungsprozesses im Temperaturbereich zwischen 550 und 800°C werden die genannten Einschlüsse nicht oder nur teilweise in der A15-Struktur gelöst, oder ein Teil des Einschlußmaterials formt mit Matrix- oder Kern-Materialien des Drahtes neue Verbindungen, welche zusätzliche Phasen bilden.

Magnetfelder bis zu einer Feldstärke von 15 Tesla können heute in kommerziellen supraleitenden Laborspulen bei Temperaturen von 4,2 K erreicht werden. Neuere Entwicklungen haben Magnetfelder von 18 T (bei 1,8 K sogar 20 T) in den Bereich des Möglichen gerückt. Um diese Felder zu erzeugen, müssen Materialien wie Nb₃Sn, V₃Ga (beide mit A15-Kristallstruktur) verwendet werden. Diese sind alle sehr spröde, mit einer Bruchdehnung um 0,1 %. Um mit dieser ungünstigen Eigenschaft fertig zu werden, wurde eine Vielzahl z.T. recht komplexer Verfahren zur Herstellung der entsprechenden Supraleiterdrähte entwickelt. Bei allen diesen Verfahren werden Teilelemente, die noch nicht die endgültigen supraleitenden Eigenschaften haben, aber noch duktil sind, mechanisch zu einem Draht mit den Endabmessungen verformt. Dieser wird dann einer Reaktionsglühung zwischen 550 und 800°C unterzogen um die supraleitende Phase zu bilden. Ein typischer Supraleiterdraht von ca. 1 mm Durchmesser besteht aus mehreren tausend Filamenten, die aus den o.g.A15-Materialien bestehen. Diese Filamente haben Durchmesser (oder charakteristische Abmessungen bei Abweichungen von der Kreisform) unterhalb 5 µm, wobei einzelne Herstellungsmethoden sogar typische Filamentabmessungen < 1 µm aufweisen.

Zur thermischen Stabilisierung besteht die äußere Hülle (oder der Kern) eines Supraleiterdrahtes aus reinem Kupfer, das durch eine Nb-oder Ta-Barriere von der Kupferbronze oder vom Supraleitermaterial getrennt ist, um Verunreinigungen bei der Reaktionsglühung zu vermeiden. Zur Verringerung der Wechselstromverluste ist der Draht um die eigene Achse verdrillt, mit einer Ganghöhe von ca. 20 mm.

Die zur Zeit gebräuchlichsten Methoden zur Herstellung von Nb₃Sn- oder V₃Ga-Multifilament -Supraleiterdrähten (Verfahrensschritt c) sind:
a) das Bronzeverfahren (A.R.Kaufmann and J.J.Pickett, J.Appl.Phys. 42, 58 (1971))
b) die externe Sn-Diffusion: für Nb₃Sn
   (M.Suenaga and W.B.Sampson, Appl.Phys.Lett., 20, 443 (1972))
c) die externe Ga-Diffusion: für V₃Ga
   (R.Bormann and H.C.Freyhardt, IEEE, Trans.Magn., Mag-17, 270 (1981))
d) die interne Sn-Diffusion: für Nb₃Sn
   (Y.Hashimoto, K.Yoshizaki und M.Tanaka, 5th. Int. Cryogenics Eng. Conf.Proc., IPC Science und Technology Press, London, p. 332, 1974)
e) die kalte pulvermetallurgische Methode: für Nb₃Sn und für V₃Ga
   (R.Flükiger, IEEE Trans.Magn., MAG-16, 1236 (1980))
f) die Modified Jelly Roll-Methode: für Nb₃Sn und für V₃Ga
   (W.K. McDonald, C.W.Curtis, R.M.Scanlan, D.C.Larbalestier, K.Marten und D.B.Smathers, IEEE Trans.Magn. MAG-19, 1124 (1983))
g) die Infiltrationsmethode: für Nb₃Sn
   (K.Hemachalam and M.R.Pickus, IEEE Trans.Magn., MAG-13, 466 (1977))
h) Die ECN-Methode: für Nb₃Sn
   (H.Veringa, P.Hoggendahm and A.C.A.Van Wees, IEEE Trans. Magn., MAG-19, 773 (1983))
i) die "In situ" Methode: für V₃Ga
   (C.C.Tsuei, Science, 180, 57 (1983))

Von allen bis heute bekannten Methoden zur industriellen Herstellung von Nb₃Sn-Vielkerndrähten haben drei die größte Verbreitung gefunden, nämlich die "Bronze-Methode", die "Modified Jelly Roll"-Methode und die Methode der "Internen Sn-Diffusion". Diese Methoden haben ein wesentliches gemeinsames Merkmal: bei der Reaktionsglühung am Ende des Drahtziehprozesses (typisch 3 Tage bei 700°C) entsteht die A15-Phase durch eine Diffusionsreaktion, d.h. Sn diffundiert aus der Cu-Sn-Bronze (welche erst zu Beginn der gewünschten Reaktion gebildet wird) und reagiert mit Nb zu Nb₃Sn.

Die Bronzemethode hat bis heute die größte Verbreitung gefunden, hat aber den Nachteil, daß die Cu-13Gew.%Sn-Bronze bei der Kaltverformung sehr stark härtet, was Erholungsglühungen nach jeweils 50 % Flächenreduktion notwendig macht. Total werden also pro Draht 15 bis 20 Glühungen von ca. 1 Stunde bei 500°C erforderlich, was den Herstellungsprozeß erheblich verlangsamt. Bei der "Modified Jelly Roll"-Methode wird von dünnen Nb und Cu-Sn-Bronzefolien ausgegangen, die um einen Kupferkern gewickelt und anschließend stranggepreßt werden. Wegen der geringen Foliendicke kommt man mit weniger Erholungsglühungen aus als bei der Bronze-Methode. Wird die Cu-Sn-Folie durch Sn ersetzt, so ergibt sich dieselbe Situation wie bei der dritten oben genannten Methode, der "internen Sn-Diffusion", bei der die Erholungsglühungen ganz wegfallen, was sich als zeitsparend und kostengünstig auswirkt. Der Umstand, daß die Kombination der Elemente Cu und Sn wesentlich einfacher zu verformen ist als die Cu-13Gew.%Sn-Bronze, ist ein weiterer Vorteil für die interne Sn-Diffusionsmethode, der deswegen gute Zukunftsaussichten eingeräumt werden.

J_{c} ist von den Haftzentren-Dichte an den Korngrenzen und somit von der Korngröße abhängig. Verschiedene Kornstrukturen wurden bis jetzt nachgewiesen: an der Nb-Grenze relativ große, säulenartige Körner (bis zu 1 µm Länge) mit starker Texturierung senkrecht zur Drahtachse, anschließend sehr feine Körner mit statistisch verteilten Orientierungen (80 bis 200nm (800 bis 2000 Å) nach einer Glühzeit von 3 Tagen bei 700°C), gefolgt von einer grobkörnigen Schicht (≧ 200 nm (2000 Å)) (W. Schauer and W. Schelb, IEEE Trans.Magn., MAG-17, 374 (1981)). Die sehr feinen Körner tragen am meisten zu J_{c} bei.

Im folgenden wird die Erfindung anhand der Beschreibung eines Durchführungsbeispiels näher erläutert:

### Beispiel 1 (Bronze-Methode):

Zur Herstellung der Proben wurden Niobpulver mit Korngrößen zwischen 106 und 125 µm verwendet. Seine Vickershärte betrug ca. 85 kg/mm². Der Zusatzstoff war Nickelpulver (ca. 20 µm Durchmesser; H_{V}= 70 - 85 kg/mm²). Abgewogene Pulvermengen wurden gemischt und dann vorsichtig - damit sie sich nicht wieder entmischen - mit einem Trichter in ein unten verschlossenes Cu-Zr-Rohr geschüttet, dessen Länge ca. 7 cm und dessen Durchmesser 9 mm war. Um eine hohe Kompaktierung zu erreichen, wurde das Pulver schon bei Teilfüllungen des Rohrs mit ca. 200 MPa vorgepreßt. Zum Verschliessen wurde ein Cu-Zr-Stopfen mit ca. 300 MPa von oben eingepreßt.

Anschließend erfolgte die Drahtherstellung, größtenteils durch Hämmern, teilweise auch durch Walzen. Um die Einschlüsse auf eine Dimension von kleiner 0,1 µm zu bringen, ist eine Querschnittsflächenreduktion Rₐ= 10⁶ erforderlich. Aufgrund der kleinen Probendurchmesser war es notwendig, den Leiter mehrfach zu bündeln. Dazu wurde bei ca. 1 mm Drahtdurchmesser das Hüllmaterial mit verdünnter Salpetersäure abgeätzt und dann 19 Stücke des Leiters wieder in ein Cu-Zr-Rohr gebündelt. Die zweite Bündelung erfolgte in ein Bronzerohr, welches dann auf den Enddurchmesser von 0,6 mm gehämmert wurde.

Die abschließende Reaktionsglühung, bei der die Nb₃Sn-A15-Struktur entstand, erfolgte bei 675°C und einer Glühdauer von 100 Stunden. Mit dem erfindungsgemäßen Verfahren wurde eine Erhöhung des J_{c}-Wertes erreicht, bei 6 T um 43,6 %, bei 8 T um 41,5 % und bei 10 T um 17,6 % gegenüber den entsprechenden J_{c}-Werten für einen Nb₃Sn-Leiter mit 100 Gew.-% Nb in der A15-Struktur ohne Ni-Einschlüsse (siehe nachfolgende Figur). Kurve 1 wurde nach dem erfindungsgemäßen Verfahren mit einem Nb₃Sn-Leiter erhalten, in welchem 85 Gew.-% Nb und 15 Gew.-% Ni (als Einschlüsse), bezogen auf die Summe (Nb + Ni), enthalten war. Kurve 2 entstand aus den J_{c}-Werten des Nb₃Sn-Leiters mit 100 Gew.-% Nb (Vergleichsleiter ohne Einschlüsse).

Die Verarbeitbarkeit der anderen angegebenen Materialien ist ähnlich der des Nickels. Verunreinigungen durch Sauerstoff, Kohlenstoff und Stickstoff in den Startmaterialien sind zu vermeiden. Die Vickershärte der gemischten Pulver muß ungefähr gleich hoch sein, damit sich die beiden Pulversorten gleichmäßig verformen.

Das Herstellungsbeispiel wurde nach der Bronze-Methode durchgeführt, der gewünschte Supraleiterdraht ließe sich aber auch nach den ähnlichen Verfahren der Internen-Zinndiffusion und der ECN-Methode produzieren.

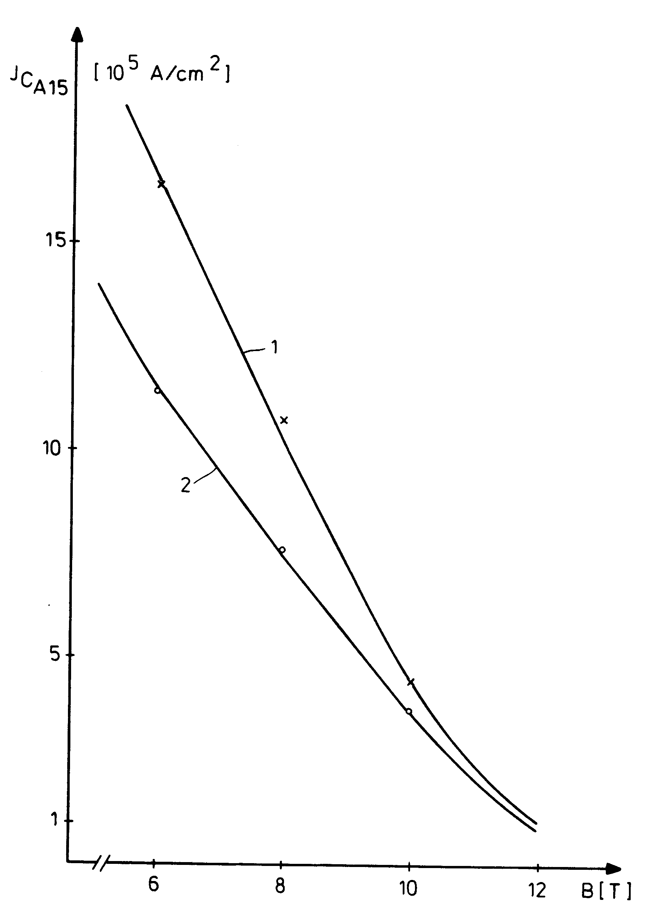

## Patentansprüche

1. Multifilament-Supraleiterdrähte, bestehend aus mit Kupfer oder mit Kupferlegierung umgebenen Filamenten, die aus supraleitenden, intermetallischen Verbindungen Nb₃Sn oder V₃Ga, jeweils mit A15-Struktur, mit Zusätzen aus der Gruppe der Elemente
Seltene Erdmetalle, Th, U, Ti, Zr, Hf, V, Nb, Ta,Mo, Fe, Co, Ni, Pd, Cu, Ag, Al, Pt, ausgenommen Nb als einziges Zusatzelement für Nb₃Sn und V als einziges Zusatzelement für V₃Ga,
aufgebaut sind, dadurch gekennzeichnet, daß
innerhalb der A15-Phase an den Korngrenzen der Kristalle und/oder an den Grenzflächen der A15-Phase zum Kupfer oder zur Kupferlegierung homogen verteilte, ungelöste Einschlüsse vorliegen, die eine weitere Phase bilden und aus mindestens einem Element der Gruppe bestehen.

2. Multifilament-Supraleiterdrähte nach Anspruch 1, dadurch gekennzeichnet, daß das oder die Elemente der Gruppe in den Einschlüssen unreagiert in elementarer Form oder als Reaktionsprodukt mit Elementen der Umgebung vorliegen.

3. Multifilament-Supraleiterdrähte nach einem der voranstehenden Ansprüche, dadurch gekennzeichnet, daß die Einschlüsse radiale Abmessungen von 0,5 µm oder kleiner aufweisen.

4. Multifilament-Supraleiterdrähte nach Anspruch 3, dadurch gekennzeichnet, daß die Einschlüsse radiale Abmessungen von < 0,1 µm aufweisen.

5. Multifilament-Supraleiterdrähte nach einem der voranstehenden Ansprüche, dadurch gekennzeichnet, daß die Einschlüsse achsenparallel ausgebildet sind.

6. Multifilament-Supraleiterdrähte nach einem der voranstehenden Ansprüche, dadurch gekennzeichnet, daß die Summe der Zusätze in den Einschlüssen einer Konzentration im Bereich von 0,1 Gew.-% bis 50 Gew.-%, bezogen auf den Nb-Anteil der A15-Phase im Falle von Nb₃Sn und bezogen auf den V-Anteil der A15-Phase im Falle von V₃Ga, entspricht.

7. Verfahren zur Herstellung von Multifilament-Supraleiterdrähten gemäß Anspruch 1, dadurch gekennzeichnet, daß man
a) ein metallisches Pulver aus einem der genannten Zusatzmetalle mit Ausnahme von V und Nb oder aus mehreren der genannten Zusatzmetalle oder aus einer oder mehreren Legierungen aus mindestens zwei der Zusatzmetalle mischt mit einem Pulver
a₁) aus Niob, oder
a₂) aus einer oder mehreren Nb-Legierungen aus der Gruppe Nb-Ta, Nb-Ti, NbZr oder
a₃) aus Vanadium oder
a₄) aus einer oder mehreren V-Legierungen aus der Gruppe V-Ta, V-Nb, V-Ti, V-Zr,
wobei alle Pulver Korngrößen aufweisen im Bereich zwischen 0,1 µm und 400 µm Durchmesser und der Anteil y des bzw. der Zusatzmetalle im Pulvergemisch einem Gewichtsprozentwert innerhalb der Grenzen 0,1 ≦ y ≦ 50 entspricht,
b) das aus a) erhaltene Pulvergemisch in einen kompaktierbaren und evakuierbaren Behälter aus Kupfer oder aus einer Kupferlegierung einfüllt, die eingeschlossene Luftmenge entfernt und danach das Pulvergemisch mit dem geschlossenen Behälter durch einfaches oder isostatisches Pressen gemeinsam kompaktiert bis zu einer Pulverdichte von mehr als 90 % theoretische Dichte und
c) den kompaktierten Behälter in an sich bekannter Weise zu einem Draht mit einem Durchmesser im Bereich von 0,5 mm bis 15 mm verformt und nach Entfernen der äußeren Cu- oder Cu-Legierungs-Schicht nach einer der bekannten Verfahrensweisen zu Nb₃Sn-Drähten oder zu V₃Ga-Drähten weiterverarbeitet.

8. Verfahren zur Herstellung von Multifilament-Supraleiterdrähten gemäß Anspruch 1, dadurch gekennzeichnet, daß man
a)Stäbe und/oder Drähte aus einem der genannten Zusatzmetalle mit Ausnahme von V und Nb oder aus mehreren der genannten Zusatzmetalle und/oder aus einer oder mehreren Legierungen aus mindestens zwei der Zusatzmetalle in Rohre
a₁ ) aus Niob, oder
a₂) aus einer oder mehreren Nb-Legierungen aus der Gruppe Nb-Ta, Nb-Ti, Nb-Zr oder
a₃) aus Vanadium oder
a₄) aus einer oder mehreren V-Legierungen aus der Gruppe V-Ta, V-Nb, V-Ti, V-Zr
einführt, wobei der Anteil z des bzw. der Zusatzmetalle im Gesamtverbund Stäbe/Drähte-Rohre einem Gewichtsprozentwert innerhalb der Grenzen 0,1 ≦ z ≦ 50 entspricht,
b) die gefüllten Rohre zu hexagonalen Querschnitten in an sich bekannter Weise plastisch verformt,
c) die hexagonalen Rohre bündelt zu einer dichten Packung, diese in ein Rohr aus Cu oder aus einer Cu-Legierung einsetzt, letztere in bekannter Weise zu runden Stäben verformt, die äußere Schicht aus Cu oder Cu-Legierungen vollständig oder teilweise entfernt und nach einer der bekannten Verfahrensweisen zu Nb₃Sn-Drähten oder zu V₃Ga-Drähten weiterverarbeitet.

## Claims

1. Multifilament superconductor wires, comprising filaments, which are surrounded by copper or by copper alloy and are constructed from superconductive, intermetallic compounds Nb₃Sn or V₃Ga, each with an A15 structure, with additions selected from the following group of elements:
rare earth metals, Th, U, Ti, Zr, Hf, V, Nb, Ta, Mo, Fe, Co, Ni, Pd, Cu, Ag, Al, Pt, except Nb as a single addition element for Nb₃Sn and V as a single addition element for V₃Ga,
characterised in that homogeneously distributed, undissolved ingredients are present internally of the A15 phase at the grain boundaries of the crystals and/or at the interfaces of the A15 phase with the copper or with the copper alloy, and said ingredients form an additional phase and comprise at least one element of the group.

2. Multifilament superconductor wires according to claim 1, characterised in that the element or the elements of the group in the ingredients are present unreacted in elementary form or as a reaction product with elements of the surroundings.

3. Multifilament superconductor wires according to one of the preceding claims, characterized in that the ingredients have radial dimensions of 0.5 µm or less.

4. Multifilament superconductor wires according to claim 3, characterized in that the ingredients have radial dimensions of < 0.1 µm.

5. Multifilament superconductor wires according to one of the preceding claims, characterised in that the ingredients are adapted to be paraxial.

6. Multifilament superconductor wires according to one of the preceding claims, characterised in that the sum of the additions in the ingredients corresponds to a concentration in the range of between 0.1 % by wt. and 50 % by wt., relative to the Nb content of the A15 phase in the case of Nb₃Sn and relative to the V content of the A15 phase in the case of V₃Ga.

7. Method of producing multifilament superconductor wires according to claim 1, characterised in that
a) a metallic powder formed from one of the above-mentioned addition metals with the exception of V and Nb or formed from a plurality of the above-mentioned addition metals or formed from one or more alloys formed from at least two of the addition metals is mixed with a powder formed from
a₁) niobium; or
a₂) one or more Nb alloys selected from the group Nb-Ta, Nb-Ti, NbZr; or
a₃) vanadium; or
a₄) one or more V alloys selected from the group V-Ta, V-Nb, V-Ti, V-Zr;
all of the powders having particle sizes with a diameter in the range of between 0.1 µm and 400 µm, and the y content of the addition metal or metals in the powder mixture corresponding to a percentage by weight within the limits 0.1 ≦ y ≦ 50;
b) the powder mixture obtained from a) is poured into a compactable and evacuatable container formed from copper or from a copper alloy, the enclosed quantity of air is removed, and then the powder mixture is compacted jointly with the closed container by simple or isostatic pressing until a powder density of more than 90 % theoretic density is reached; and
c) the compacted container is shaped in a manner known per se to form a wire having a diameter in the range of between 0.5 mm and 15 mm and, after removal of the outer layer of Cu or Cu alloy, it is further processed, according to one of the known processes, to form Nb₃Sn wires or V₃Ga wires.

8. Method of producing multifilament superconductor wires according to claim 1, characterised in that
a) rods and/or wires formed from one of the above-mentioned addition metals with the exception of V and Nb or formed from a plurality of the above-mentioned addition metals and/or formed from one or more alloys formed from at least two of the addition metals are introduced into tubes formed from
a₁) niobium; or
a₂) one or more Nb alloys selected from the group Nb-Ta, Nb-Ti, NbZr; or
a₃) vanadium; or
a₄) one or more V alloys selected from the group V-Ta, V-Nb, V-Ti, V-Zr;
the z content of the addition metal or metals in the total complex of rods/wires and tubes corresponding to a percentage by weight within the limits 0.1 ≦ z ≦ 50;
b) the filled pipes are plastically deformed in a manner known per se to form hexagonal cross-sections; and
c) the hexagonal tubes are bundled together to form a tight package, the latter is inserted into a tube formed from Cu or from a Cu alloy, the latter is deformed in known manner to form round rods, the outer layer of Cu or Cu alloys is removed totally or partially and further processed, according to one of the known processes, to form Nb₃Sn wires or V₃Ga wires.

## Revendications

1. Fils supraconducteurs multibrins, constitués de brins entourés de cuivre ou d'un alliage de cuivre, qui sont constitués de composés intermétalliques supraconducteurs Nb₃Sn ou V₃Ga, chacun à structure A15, avec des additions d'éléments choisis parmi :
- les terres rares, Th, U, Ti, Zr, Hf, V, Nb, Ta, Mo, Fe, Co, Ni, Pd, Cu, Ag, Al, Pt, à l'exception de Nb en tant qu'élément unique d'addition pour Nb₃Sn et de V en tant qu'élément unique d'addition pour V₃Ga,
caractérisés en ce que, à l'intérieur de la phase A15, sont présentes des inclusions non dissoutes, répartis de façon homogène aux joints de grains des cristaux et/ou aux interfaces de la phase A15 avec le cuivre ou l'alliage de cuivre, qui forment une autre phase et sont constituées d'au moins un élément du groupe.

2. Fils supraconducteurs multibrins selon la revendication 1, caractérisés en ce que l'élément ou les éléments du groupe est présent dans les inclusions à l'état non réagi, sous forme élémentaire ou sous forme d'un produit de réaction avec des éléments de l'environnement.

3. Fils supraconducteurs multibrins selon l'une quelconque des revendications précédentes, caractérisés en ce que les inclusions présentent des dimensions radiales de 0,5 µm ou moins.

4. Fils supraconducteurs multibrins selon la revendication 3, caractérisés en ce que les inclusions présentent des dimensions radiales < 0,1 µm.

5. Fils supraconducteurs multibrins selon l'une quelconque des revendications précédentes, caractérisés en ce que les inclusions ont une configuration parallèle à l'axe.

6. Fils supraconducteurs multibrins selon l'une quelconque des revendications précédentes, caractérisés en ce que la somme des inclusions correspond à une concentration dans la plage allant de 0,1 à 50 % en poids, par rapport à la fraction Nb de la phase A15 dans le cas de Nb₃Sn et par rapport à la fraction V de la phase A15 dans le cas de V₃Ga.

7. Procédé pour la fabrication de fils supraconducteurs multibrins selon la revendication 1, caractérisé en ce que :
a) on mélange une poudre métallique composée d'un desdits métaux d'addition, à l'exception de V et Nb, ou de plusieurs desdits métaux d'addition, ou d'un ou plusieurs alliages d'au moins deux des métaux d'addition, avec une poudre :
a1) de niobium, ou
a2) d'un ou plusieurs alliages de Nb, choisis parmi Nb-Ta, Nb-Ti, Nb-Zr ou,
a3) de vanadium ou,
a4) d'un ou plusieurs alliages de V, choisis parmi V-Ta, V-Nb, V-Ti, V-Zr,
toutes les poudres présentant des tailles de grains dans la plage comprise entre 0,1 µm et 400 µm de diamètre, et la fraction y du métal ou des métaux d'addition correspondant dans le mélange de poudres à un pourcentage en poids rentrant dans les limites 0,1 ≦ y ≦ 50,
b) on introduit le mélange de poudres, obtenu en b), dans un récipient en cuivre ou en un alliage de cuivre, compressible et apte à être mis sous vide, on élimine la quantité d'air incluse et ensuite on comprime le mélange de poudres, avec le récipient fermé, par compression simple ou isostatique, jusqu'à une densité de poudre de plus de 90 % de la densité théorique, et
c) on met le récipient comprimé, d'une façon connue en soi, sous forme d'un fil ayant un diamètre dans la plage allant de 0,5 mm à 15 mm, et, après avoir éliminé la couche externe de Cu ou d'alliage de Cu, on le transforme, selon l'un des modes opératoires connus, en fils de Nb₃Sn ou en fils de V₃Ga.

8. Procédé pour la fabrication de fils supraconducteurs multibrins selon la revendication 1, caractérisé en ce que :
a) on introduit des baguettes et/ou des fils en un desdits métaux d'addition, à l'exception de V et Nb, ou en plusieurs desdits métaux d'addition et/ou en un ou plusieurs alliages d'au moins deux des métaux d'addition, dans des tubes,
a1), en niobium, ou
a2) en un ou plusieurs alliages de Nb, choisis parmi Nb-Ta, Nb-Ti, Nb-Zr ou
a3) en vanadium ou,
a4) en un ou plusieurs alliages de V choisis parmi V-Ta, V-Nb, V-Ti, V-Zr,
la fraction z du métal ou des métaux d'addition correspondant, dans le composite total baguettes/fils-tubes, à un pourcentage en poids rentrant dans les limites 0,1 ≦ z ≦ 50,
b) on soumet les tubes remplis à une déformation plastique, d'une façon connue en soi, aboutissant à des sections transversales hexazonales,
c) on assemble les tubes hexazonaux en un paquet dense, on introduit celui-ci dans un tube de Cu ou d'un alliage de Cu, on met celui-ci, d'une façon connue, sous forme de baguettes rondes, on élimine en partie ou en totalité la couche externe de Cu ou d'alliages de Cu, puis on les transforme, selon l'un des modes opératoires connus, en fils de Nb₃Sn ou en fils de V₃Ga.
